(19) Europäisches Patentamt
European Patent Office
Office européen des brevets

(11) EP 0 733 952 A1

(12) EUROPEAN PATENT APPLICATION

(43) Date of publication:
**25.09.1996 Bulletin 1996/39**

(51) Int Cl.[6]: **G03F 7/004**

(21) Application number: **96301729.8**

(22) Date of filing: **14.03.1996**

(84) Designated Contracting States:
**BE CH DE FR GB IT LI NL**

(30) Priority: **23.03.1995 CH 831/95**

(71) Applicant: **OCG MICROELECTRONICS MATERIALS, INC.**
**Cheshire, CT 06410-0586 (US)**

(72) Inventors:
- **Mertesdorf, Carl-Lorenz**
**79189 Bad Krozingen (DE)**
- **Muenzel, Norbert**
**79423 Heltersheim (DE)**
- **Schacht, Hans-Thomas**
**79618 Rheinfelden (DE)**
- **Falcigno, Pasquale Alfred**
**4052 Basle (CH)**

(74) Representative: **Baker, Colin John et al**
**Withers & Rogers,**
**4 Dyer's Buildings,**
**Holborn**
**London EC1N 2JT (GB)**

(54) **Photoresist compositions**

(57) A radiation-sensitive composition comprising, based on the total amount of components A, B and C,

(A) 60-97.9% by weight of at least one polymer having a mean molecular weight $M_w$ (weight average) of from 4000 to 1,000,000 (measured by gel permeation chromatography) and comprising structural repeating units of the formulae I-IV

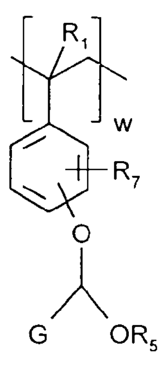

(I),

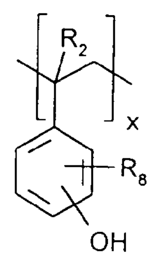

(II),

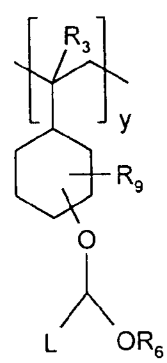

(III),

EP 0 733 952 A1

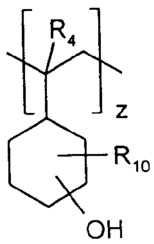

(IV),

in which $R_1$, $R_2$, $R_3$ and $R_4$, independently of one another, are hydrogen, methyl or halogen, $R_5$ and $R_6$, independently of one another, are $C_1$-$C_6$alkyl or unsubstituted or mono- or poly-$C_1$-$C_4$alkyl-substituted cycloalkyl, $R_7$, $R_8$, $R_9$ and $R_{10}$, independently of one another, are hydrogen, $C_1$-$C_6$alkyl, $C_1$-$C_6$alkoxy or halogen, G is a methyl group, or G and $R_5$, together with the O and C atoms bonded to these radicals, form a five- to eight-membered ring, L is a methyl group, or L and $R_6$, together with the O and C atoms bonded to these radicals, form a five- to eight-membered ring, w, x, y and z are numbers which are equal to or greater than one, with the proviso that $0.05 \leq Q \leq 0.40$, where the quotient $Q = (w + y)/(w + x + y + z)$, obtainable from the total number of structural the total number of all structural units present,

(B) 2-39.9% by weight of a dissolution inhibitor comprising one or more compounds having a molecular weight of up to 3000 containing at least one acid-labile C-O-C or C-O-Si bond, and

(C) 0.1-20% by weight of a substance which forms an acid on exposure to actinic radiation,

has a long shelf life, good process stability and a high resolution capacity and is particularly suitable as a DUV photoresist.

## Description

### BACKGROUND OF THE INVENTION

1. Field of the Invention

The present invention relates to radiation-sensitive compositions comprising specific polymers containing hydroxyl groups and acid-labile side groups, an acid-labile inhibitor and an acid photogenerator, to a process for the production of positive images using these compositions, and to the use of the compositions as positive resists.

2. Brief Description of the Relevant Art

The production of highly integrated circuits currently requires the ability for structures having a width of less than 0.35 μm to be transferred imagewise to the substrate. The resolving power, for example of an o-quinone diazide (novolak) system, has, at the wavelength of 365 nm used for imagewise exposure, reached the limits of the physically possible. For this reason, there is increasing interest in photoresists which operate at relatively short wavelengths in the deep ultraviolet (DUV) region from 200 to 300 nm. Novolaks absorb so strongly in this region that uniform exposure over the usual layer thickness of approximately 1.0 μm is impossible. In order to ensure the requisite optical transparency, poly(p-hydroxystyrene) or derivatives thereof are generally used as binder resins in photoresists working in the DUV region.

Known systems of increased radiation sensitivity comprise, for example, alkali-soluble binder resins and an organic compound which inhibits the alkali solubility of the binder resin (dissolution inhibitor), and an acid photogenerator. These dissolution inhibitors generally contain hydroxyl or carboxyl groups which are blocked by acid-labile protecting groups, as described, for example, in U.S. Patent 5,310,619. Exposure then initiates a primary reaction of the acid photogenerator, which absorbs at the corresponding wavelength, forming a strong acid, which, in the subsequent secondary reaction, causes removal of the protecting groups and thus re-formation of the solubilizing groups. The dissolution inhibitor thus loses its inhibition ability, and the exposed areas consequently become soluble in the aqueous-alkaline developer. In the removal reaction, a proton is liberated again and catalyses further deprotection cycles.

The photoresists described in U.S. Patent 5,310,619 comprise novolaks as binder resin. The alkali solubility of novolaks is known to be easier to inhibit than the alkali solubility of poly(p-hydroxystyrene) (R. Dammel et al., SPIE Vol. 2195, Advances in Resist Technology and Processing XI 542-557 (1994). However, resins based on poly(p-hydroxystyrene) are preferred for the preparation of DUV photoresists owing to their low absorption in the deep UV region.

EP-A-541,112 therefore proposes radiation-sensitive compositions comprising three components which comprise a polymeric binder which is insoluble in water, but soluble in aqueous-alkaline solutions, for example poly(p-hydroxystyrene), and a dissolution inhibitor containing at least two groups which can be removed by means of a strong acid and are separated from one another by at least 10 atoms. The inhibition in these photoresists is adequate when dilute aqueous-alkaline developers are used. However, the more highly concentrated alkaline developer solutions that are usual in the process are unsuitable, since an unacceptably high reduction in coating thickness occurs in the unexposed areas of the resist film.

The inadequate dissolution inhibition can be improved by additionally blocking some of the hydroxyl groups in the binder resins by means of acid-labile protecting groups. Such systems are described, for example, in EP-A-558,280.

DE-A-4,410,441 discloses photosensitive compositions comprising a partly protected p-hydroxystyrene, a dissolution inhibitor and an acid photogenerator which give a good profile and a high resolution capacity without standing waves.

However, it is known that thermal stability losses increasingly occur in partly protected polymers comprising free phenolic monomer units. Thermally induced decomposition (autocatalysis) is attributable to partial deprotection owing to the catalytic effect of the weakly acidic phenolic hydroxyl groups (H. Ito, J. Polym. Sci., Part A, 24, 2971-2980, 1986). The decomposition temperature of such polymers drops with decreasing protecting-group content owing to increasing autocatalysis (P.J. Paniez et al., SPIE Vol. 2195, Advances in Resist Technology and Processing XI, 14-27 (1994)). Photoresists comprising such polymers have the disadvantage of low thermal stability, in particular if the acid lability of the protecting groups used is high and the degree of protection is low (<50%). The process latitude and the shelf life of such photoresists are thus greatly restricted, and excessive layer removal from unexposed areas can be the result.

### BRIEF SUMMARY OF THE INVENTION

It has not been found that a combination of polyhydroxystyrenes which have been partly protected by means of specific protecting groups or partially hydrogenated polyhydroxystyrenes with a dissolution inhibitor and an acid photogenerator gives highly active resist compositions which are distinguished by high transparency in the DUV region, a

long shelf life, good process stability and a high resolution capacity.

In spite of the relatively low protecting-group contents, the polymers used have high thermal stability, since, surprisingly, deprotection by autocatalysis only occurs to a small extent.

The present invention relates to a radiation-sensitive composition comprising, based on the total amount of components A, B and C,

(A) 60-97.9% by weight of at least one polymer having a mean molecular weight $M_w$ (weight average) of from 4000 to 1,000,000 (measured by gel permeation chromatography) and comprising structural repeating units of the formulae I-IV

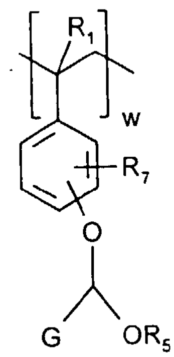

(I),

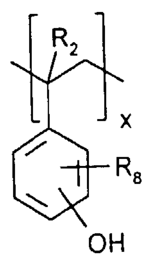

(II),

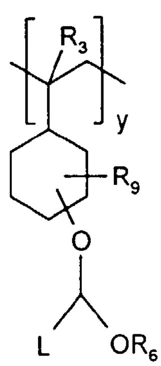

(III),

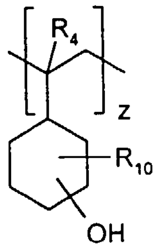

(IV),

in which $R_1$, $R_2$, $R_3$ and $R_4$, independently of one another, are hydrogen, methyl or halogen, $R_5$ and $R_6$, independently of one another, are $C_1$-$C_6$alkyl or unsubstituted or mono- or poly-$C_1$-$C_4$alkyl-substituted cycloalkyl, $R_7$, $R_8$, $R_9$ and $R_{10}$, independently of one another, are hydrogen, $C_1$-$C_6$alkyl, $C_1$-$C_6$alkoxy or halogen, G is a methyl group or G and $R_5$, together with the O and C atoms bonded to these radicals, form a five- to eight-membered ring, L is a methyl group, or L and $R_6$, together with the O and C atoms bonded to these radicals, form a five- to eight-membered ring,

w, x, y and z are numbers which are equal to or greater than one, with the proviso that $0.05 \leq Q \leq 0.40$, where the quotient Q = (w+y)/(w+x+y+z), obtainable from the total number of structural units containing protecting groups divided by the total number of all structural units present,

(B) 2-39.9% by weight of a dissolution inhibitor comprising one or more compounds having a molecular weight of up to 3000 containing at least one acid-labile C-O-C or C-O-Si bond, and

(C) 0.1-20% by weight of a substance which forms an acid on exposure to actinic radiation.

## DETAILED DESCRIPTION OF PREFERRED EMBODIMENTS

Component A is preferably a polymer comprising structural repeating units of the formulae V-VIII

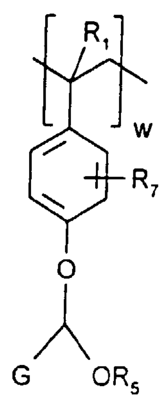

(V),

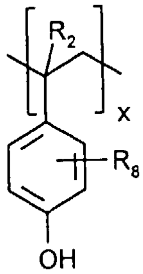

(VI),

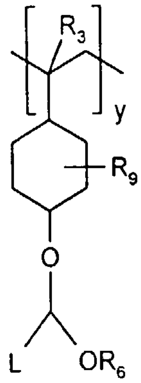

(VII),

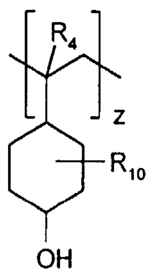

(VIII),

in which $R_1$ to $R_{10}$, G, L, w, x, y and z are as defined above.

Alkyl groups as substituents $R_5$ to $R_{10}$ can be straight-chain or branched. Examples which may be mentioned are methyl, ethyl, n-propyl, isopropyl, n-butyl, sec-butyl, isobutyl, tert-butyl, n-pentyl, neopentyl, isopentyl, n-hexyl and isohexyl.

Alkoxy groups as substituents $R_7$ to $R_{10}$ can be, for example, methoxy, ethoxy, n-propoxy, isopropoxy, n-butoxy or tert-butoxy.

Halogen atoms as substituents $R_1$ to $R_4$ or $R_7$ to $R_{10}$ are preferably fluorine, chlorine or bromine, but in particular chlorine.

Preference is given to polymers comprising structural repeating units of the formulae I-IV in which $R_1$ to $R_4$ and $R_7$ to $R_{10}$ are hydrogen.

In the formulae I-IV, $R_5$ and $R_6$, independently of one another, are preferably methyl, ethyl, n-propyl, isopropyl, n-butyl, isobutyl or tert-butyl, or $R_5$ and $R_6$, together with G or L and the adjacent O and C atoms, form a tetrahydrofuran or tetrahydropyran ring.

Particular preference is given to polymers in which $R_5$ and $R_6$ in the formulae I-IV are methyl, ethyl or tert-butyl.

Preference is furthermore given to polymers based on partially hydrogenated p-hydroxystyrenes, i.e. polymers comprising structural repeating units of the formulae I-IV in which y and z are numbers equal to or greater than 1.

The polymers of components A preferably have a molecular weight $M_w$ of from 4500 to 100,000, particularly preferably from 5000 to 50,000, in particular from 5500 to 20,000.

The protecting-group content in the polymers of component A is preferably from 10% to 35%, in particular from 15% to 30%, i.e. the quotient Q is preferably $0.10 \leq Q \leq 0.35$, in particular $0.15 \leq Q \leq 0.30$.

The ratio between aromatic and cycloaliphatic structures in the polymers of component A can be varied within broad limits.

The novel polymers preferably comprise 1-40%, in particular 2-15%, of structural units of the formulae III and IV and 60-99%, in particular 85-98%, of structural units of the formulae I and II, based on the total number of all structural units.

The polymers of component A can be random copolymers or block copolymers which can be prepared by methods known per se.

Random copolymers can be obtained, for example, by copolymerization of the monomers of the formulae Ia-IVa

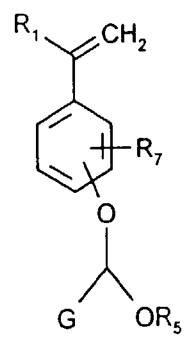

(Ia),

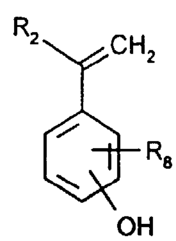

(IIa),

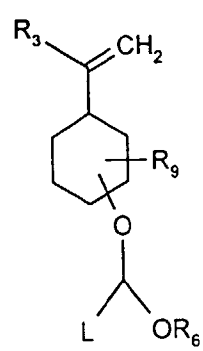

(IIIa),

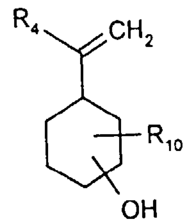

(IVa),

in which $R_1$ to $R_{10}$ are as defined above. The initial amounts of the monomers are obtained from the ratio between the parameters w, x, y and z in the polymer comprising the structural units I-IV, as described above.

A preferred process for the preparation of the polymers of component A in which $R_1 = R_2$, $R_7 = R_8$, $R_3 = R_4$ and $R_9 = R_{10}$ is reaction of a polymer comprising structural repeating units of the formulae Ic and, if desired, IIc

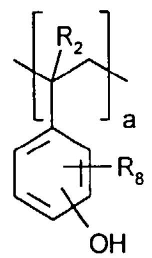

(Ic),

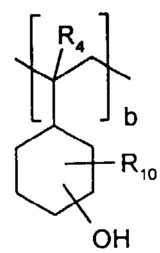

(IIc)

in which a = w + x and b = y + z, and $R_2$, $R_4$, $R_8$ and $R_{10}$ are as defined in the formulae II and IV, with a suitable enol ether.

The protecting-group content of the polymer arises in this reaction from the amount of enol ether employed; in order to prepare a polymer comprising w mol of structural units of the formula I and y mol of structural units of the formula III, at least c mol of enol ether are employed, where c = w + y.

The starting compounds for the preparation of the polymers are known, and in some cases are commercially available.

A copolymer comprising structural units Ic and IIc in which $R_2$, $R_4$, $R_8$ and $R_{10}$ are hydrogen can be prepared, for example, by metal-catalysed partial hydrogenation of polyhydroxystyrene, as described in JP-A 01-103 604.

Dissolution inhibitors containing acid-labile O-C bonds or O-Si bonds and having a molecular weight of up to 3000 which are suitable as component B are known to the person skilled in the art and are described, for example, in EP-A-562,819, EP-A-541,112, EP-A-520,265, EP-A-367,131, EP-A-367,132 and in U.S. Patents 5,310,619 and 5,352,564.

Component B in the novel compositions is preferably a compound of the formula IXa or IXb

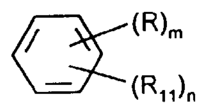

(IXa),

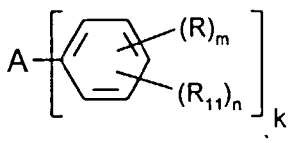

(IXb),

in which A is a k-valent organic radical, k is an integer from 2 to 6, R is an acid-labile group, $R_{11}$ is $C_1$-$C_6$alkyl, $C_1$-$C_6$alkoxy, hydroxyl or halogen, m is an integer from 1 to 5, and n is an integer from 0 to 4, where $n + m \leq 5$.

In the formulae IXa and IXb, R is preferably tetrahydropyranyloxy, tetrahydrofuranyloxy, $-OC(CH_3)R_{12}-OR_{13}$, $-OCR_{14}R_{15}R_{16}$, $-OSi(R_{15})_3$, $-OCR_{17}R_{18}-Ar$, $-OCH_2-CR_{14}=CR_{15}R_{16}$ $-O(CR_{12}R_{14})_pCOOX$ or $-(CR_{12}R_{14})_p-COOX$, where $R_{12}$ is hydrogen, $C_1$-$C_6$alkyl or phenyl, $R_{13}$ is $C_1$-$C_6$alkyl or phenyl, $R_{14}$ is hydrogen or $C_1$-$C_6$alkyl, $R_{15}$ and $R_{16}$ are $C_1$-$C_6$alkyl, $R_{17}$ and $R_{18}$, independently of one another, are hydrogen or $C_1$-$C_6$alkyl, Ar is a $C_5$-$C_{20}$aryl group, and X is tetrahydropyranyl, tetrahydrofuranyl, $-C(CH_3)R_{12}-OR_{13}$, $-CR_{14}R_{15}R_{16}$, $-Si(R_{15})_3$, $-CR_{17}R_{18}-Ar$ or $-CH_2-CR_{14}=CR_{15}R_{16}$ and p is a number from 1 to 4.

Alkyl groups as substituents $R_{11}$ to $R_{18}$ can be straight-chain or branched. Examples which may be mentioned are methyl, ethyl, n-propyl, isopropyl, n-butyl, sec-butyl, isobutyl, tert-butyl, n-pentyl, neopentyl, isopentyl, n-hexyl and isohexyl.

Examples of $C_5$-$C_{20}$aryl groups are phenyl, tolyl, mesityl, isityl, naphthyl and anthryl. Phenyl is preferred.

Component B is particularly preferably a compound of the formula X

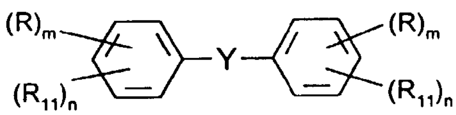

(X),

in which R, $R_{11}$, m and n are as defined above, and Y is -CO-, -COO-, -SO-, $-SO_2-$ or $-CR_{17}R_{18}-$, in which $R_{17}$ and $R_{18}$, independently of one another, are hydrogen or $C_1$-$C_6$alkyl.

Component B is especially preferably a compound of the formula XI, XII, XIII, XIV, XV or XVI

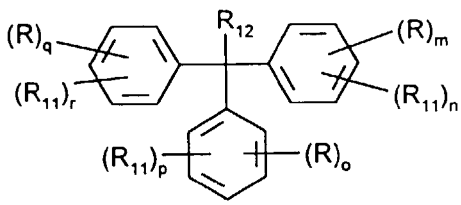

(XI),

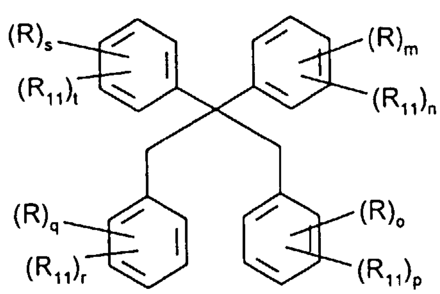

(XII),

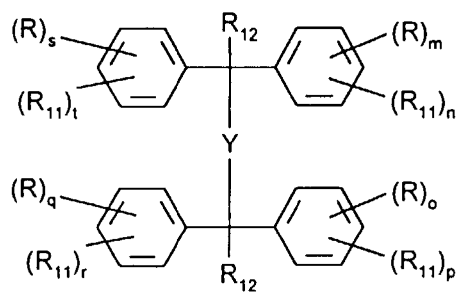

(XIII),

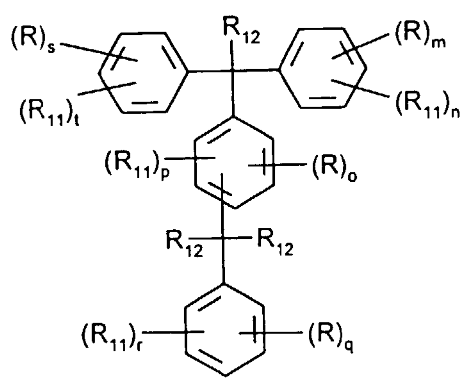

(XIV),

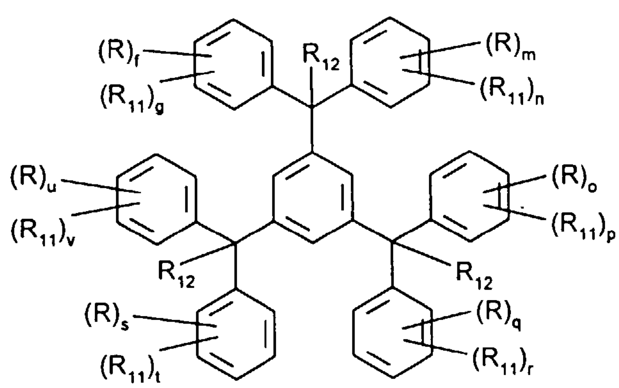

(XV),

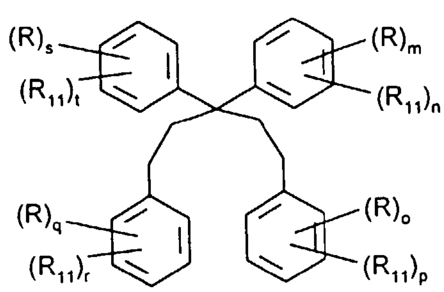

(XVI),

in which R and $R_{11}$ are as defined above, $R_{12}$ is hydrogen, $C_1$-$C_6$alkyl or phenyl, Y is -CO-, -COO-, -SO-, -$SO_2$- or -$CR_{17}R_{18}$-, in which $R_{17}$ and $R_{18}$, independently of one another, are hydrogen or $C_1$-$C_6$alkyl, m, o, q, s, u and f are integers from 1 to 5, and n, p, r, t, v and g are integers from 0 to 5, where $n + m \leq 5$, $o + p \leq 5$, $q + r \leq 5$, $s + t \leq 5$, $u + v \leq 5$ and $f + g \leq 5$.

The molecular weight of the dissolution inhibitor to be used as component B is preferably at most 2000, in particular at most 1500.

The radiation-sensitive component C which forms or eliminates acids on exposure to actinic radiation can be any of a multiplicity of compounds. These include, for example, diazonium salts, as used in the diazo process, o-quinone diazides, as used in known positive-working copying compositions, or alternatively halogen compounds which form hydrohalic acid on irradiation. Compounds of this type are described, for example, in U.S. Patents 3,515,552, 3,536,496 and 3,779,778 and in DE-A-2,718,259, DE-A-2,243,621 and DE-A-2,610,842.

Suitable radiation-sensitive components C in the novel compositions are in particular cationic photoinitiators from the group consisting of iodonium and solfonium salts. Such compounds are described, for example, in "UV-Curing, Science and Technology" (Editor: S.P. Pappas, Technology Marketing Corp., 642 Westover Road, Stamford, Connecticut, USA).

It is furthermore possible for the radiation-sensitive compounds used to be sulfoxonium salts. Such salts are described, for example, in EP-A-35,969, EP-A-44,274 and EP-A-54,509.

Particular mention should be made of aliphatic sulfoxonium salts which absorb in the deep UV region.

It is also possible to use sulfonic esters, as described, for example, in U.S. Patents 5,118,582 and 5,189,402 and in T. Ueno et al., Polym. Eng. Sci. 32, 1511 (1992). Also suitable are further sulfonic esters, for example n-sulfonyloxyimides, as described in EP-A-502,677, and nitrobenzyl sulfonates, as described in U.S. Patent 5,135,838. Other sulfonyl compounds which can be used are mentioned, for example, in DE-A-4,225,422 and in Polym. Eng. Sci. 32, 1476 (1992).

For irradiation with short-wave UV rays or electron beams, particular preference is given to disulfone compounds, for example phenyl cumyl disulfone and phenyl 4-anisyl disulfone, as described in DE-A-3,804,316.

Also suitable are, in particular, iminosulfates, as described, for example, in EP-A-241,423 and EP-A-571,330.

It is also possible to use compounds which liberate sulfonic acids on exposure to actinic light. Such compounds are known and are described, for example, in GB-A-2,120,263, EP-A-84,515, EP-A-37,152 and EP-A-58,638 and in U.S. Patents 4,258,121 and 4,371,605. Compounds which liberate carboxylic acids on irradiation can also be used. Such compounds are described, for example, in EP-A-552,548.

Salts used as the radiation-sensitive, acid-eliminating components C should preferably be soluble in organic solvents. Particularly preferred salts here are those of complex acids, for example tetrafluoroboric acid, hexafluorophosphoric acid, trifluoromethanesulfonic acid, hexafluoroarsenic acid or hexafluoroantimonic acid.

The novel compositions preferably comprise, based on the total amount of components A, B and C, 60-94.9% by weight of component A, 5-30% by weight of component B and 0.1-10% by weight of component C.

The invention furthermore relates to radiation-sensitive compositions which additionally comprise, in addition to components A, B and C, an organic solvent as component D.

The choice of organic solvent in component D and its concentration depend principally on the type of composition of the resist formulation and on the coating method. The solvent should be inert, i.e. it should not undergo any chemical reactions with components A, B and C, and it should be removable again on drying after coating. Examples of suitable solvents are ketones, ethers, esters, and aromatic compounds, and any desired mixtures thereof. Examples thereof are methyl ethyl ketone, isobutyl methyl ketone, cyclopentanone, cyclohexanone, N-methylpyrrolidone, dioxane, tetrahydrofuran, 2-methoxyethanol, 2-ethoxyethanol; acetates, such as butyl acetate; furthermore 1-methoxy-2-propanol, 1,2-dimethoxyethane, diethylene glycol dimethyl ether, butyl glycol, alkylene glycol monoalkyl ethers, for example ethylcellosolve, ethylene glycol monobutyl ether and methylcellosolve; alkylene glycol alkyl ether esters, such as methylcellosolve acetate, ethylcellosolve acetate, propylene glycol ethyl ether acetate and methoxypropyl acetate; furthermore ethyl acetate, n-butyl acetate, ethyl 3-ethoxypropionate and methoxymethyl propionate, ethyl lactate, toluene and xylene. Preferred organic solvents are ethyl lactate, ethoxyethyl propionate and in particular methoxypropyl acetate.

In addition to components A, B, C and, if used, D, the novel compositions may additionally comprise from 0.01 to 40% by weight of conventional additives as component E.

Conventional additives are, for example, the following substances:

Pigments or dyes in amounts of from about 0.1 to 2% by weight, based on the total amount of components A, B and C, for example Mikrolith Blau 4G, Orasolblau GN and Irgalithgrun;

organic or inorganic fillers in amounts from 5 to 15% by weight, based on the total amount of components A, B and C, such as talc, quartz ($SiO_2$), barium sulfate ($BaSO_4$), aluminum oxide and calcium carbonates, by means of which, for example, the properties of a coating, such as heat resistance, adhesion or scratch resistance, can be improved;

weakly basic additives (paint additives) in a total amount of from 0.01 to 10% by weight, based on the total amount

of components A, B and C, such as antifoams (for example Byk 80), adhesion promoters (for example benzotriazole), fungicides and thixotropic agents, or hydroxyl-terminated polyglycol ethers comprising ethylene oxide and/or propylene oxide units, for example Tetronic 701, 901, 908P and 1501 (BASF products);

surfactants for improving the wettability of the composition, for preventing streaking on the resultant film, for improving the developability of the exposed area, etc. Surfactants include nonionic surfactants, for example polyoxyethylene lauryl ether, polyoxyethylene stearyl ether, polyoxyethylene oleyl ether, polyoxyethylene octylphenol ether, polyoxyethylene nonylphenol ether, polyoxyethylene glycol dilaurate, polyethylene glycol distearate; fluorine-containing surfactants, for example F Top EF 301, EF 303 and EF 352 (Shin Akita Kasei K.K. products), Megafac F 171 and F 173 (Dainippon Ink & Chemicals products), Fluorad FC 430 and FC 431 (Sumitomo 3M Limited products), Asahi Guard AG 710, Surflon S-382, Surflon SC 101, SC 102, SC 103, SC 104, SC 105 and SC 106 (Asahi Glass Co., Ltd. products). Also used are, for example, the organosiloxane polymer KP 341 (Shin-Etsu Chemical Co. Ltd. product) and Polyflow No. 75 and No. 95 (Kyoeisha Yushikagaku Kogyo K.K. products), which are acrylic acid or methacrylic acid polymers. The amount of surfactant used is about 0.01-0.1% by weight, based on the total amount of components A, B and C;

more highly basic additives, such as aromatic or aliphatic amines, ammonium salts or N-containing heterocyclic compounds, usually in a concentration of from 0.01 to 1% by weight, based on the total amount of components A, B and C; examples of such basic additives are 2-methylimidazole, triisopropylamine, 4-dimethylaminopyridine and 4,4'-diaminodiphenyl ether.

Component E is preferably an aliphatic or aromatic amine.

The novel resist formulations are prepared, for example, by mixing components A, B, C, and if used, D and E with stirring at room temperature, giving a homogeneous solution.

The resist formulation is applied uniformly to the substrate at room temperature by known coating methods, for example by immersion, knife coating, brushing, spraying, in particular by electrostatic spraying, or reverse-role coating and especially by spin coating.

The application rate (layer thickness) and the type of substrate (layer support) depend on the desired area of application. The layer thickness is generally in the range from 0.1 to greater than 10 mm, preferably from 0.2 to 2.0 mm.

In microelectronics, the substrate is, for example, a surface-oxidized silicon wafer.

After coating, the solvent is generally removed by drying, for example at temperatures of from 70°C to 130°C.

The resist film is a photoresist which, after drying, has high sensitivity to actinic radiation and has very good adhesion to the substrate. It furthermore has high transparency and sensitivity even in the deep UV region, in particular at 248 nm, and has good thermal stability.

In order to produce relief structures, the substrate coated with the novel composition is exposed imagewise. The term "imagewise" exposure includes both exposure through a photomask carrying a predetermined pattern, for example a transparency, and exposure by means of a laser beam moved over the surface of the coated substrate, for example under computer control, and in this way generates an image, irradiation with computer-controlled electron beams and exposure to X-rays or UV rays through an appropriate mask.

In general, the exposure is carried out using UV and/or VIS radiation, preferably having a wavelength of from about 190 to 1000 nm, in particular from 190 to 300 nm, especially from 245 to 250 nm. In principle, the irradiation can be carried out using all radiation sources known per se, for example high-pressure mercury lamps or UV/VIS lasers and especially excimer lasers (KrF excimer laser light having a wavelength of 248 nm). The radiation source can also be X-rays (for example synchrotron rays) or rays of charged particles (for example electron beams), inter alia. The process parameters, for example the irradiation duration and the distance between the radiation source and the radiation-sensitive layer, generally depend on the type of radiation-sensitive composition and on the desired properties of the coating and can be determined by the person skilled in the art on the basis of a few routine experiments.

After imagewise exposure, the wafer is, if desired, heated at from 50°C to 150°C for from a few seconds to a few minutes (post exposure bake).

The exposed areas of the photoresist are subsequently removed by dissolution in a developer. The choice of the particular developer depends on the type of photoresist, in particular on the nature of the binder used or of the photolysis products formed. The developer can be an aqueous solution of bases to which, if desired, wetting agents and organic solvents or mixtures thereof have been added.

The novel compositions are preferably used as positive resists. The invention therefore furthermore relates to a process for the production of positive images which comprises the following steps:

(I.) coating of a substrate with a radiation-sensitive composition comprising components A, B, C and, if desired, D and E,
(II.) exposure of the coated substrate to actinic radiation in a predetermined pattern, and
(III.) development of the exposed substrate using a developer for positive-working resists.

Particularly preferred developers are aqueous-alkaline solutions, as also employed for development of o-quinone

diazide/novolak resist coatings. These include, for example, aqueous solutions of alkali metal silicates, phosphates, hydroxides and carbonates, but in particular of tetraalkylammonium hydroxide, for example of tetramethylammonium hydroxide. Relatively small amounts of wetting agents and/or organic solvents can, if desired, also be added to these solutions. Typical organic solvents which can be added to the developer liquids are, for example, cyclohexanone, 2-ethoxyethanol, acetone, isopropanol, ethanol and mixtures of two or more of these solvents.

The developer is preferably applied by immersing the coated and imagewise-exposed substrate into the developer solution, by spraying-on the developer solution or by repeated application of the developer to the coated and imagewise-exposed substrate, followed by removal by spinning.

The invention furthermore relates to the use of the novel compositions as positive resists for the production of printing plates, printed circuits or integrated circuits, and to the printing plates, printed circuits and integrated circuits produced using the novel compositions.

The following examples below further illustrate the present invention. All parts and percentages are by weight and temperature are degree Celsius unless explicitly stated otherwise.

Synthesis Example 1: Preparation of poly[4-(1-ethoxyethoxy)styrene/4-(1-ethoxyethoxy) vinylcyclohexane/4-hydroxystyrene/ 4-vinylcyclohexanol] having a protecting-group content of 18% and a hydroxyl-group content of 82%.

7.1 g of ethyl vinyl ether are slowly added dropwise at 10°C to a solution of 20.0 g of partially hydrogenated poly-4-hydroxystyrene (Maruka Lyncur® PHM-C) and a catalytic amount of toluene-4-sulfonic acid in 120 ml of 1,4-dioxane. The reaction mixture is stirred at room temperature for 3 hours, and the catalyst acid is then removed. The polymer is then precipitated by introducing the resultant reaction solution into an isopropanol/water mixture. The polymer is filtered off, washed with an isopropanol/water mixture and subsequently dried to constant weight under reduced pressure. 16.0 g of a colorless powder are obtained which has the following properties:

- Thermogravimetric analysis TGA (10°C/min) :
  Difference Δ (in the region below 290°C):

  $$\Delta = 10.0\% \text{ by weight} \rightarrow Q = 0.18$$

  This corresponds to a polymer having a protecting-group content of 18% and a hydroxyl-group content of 82%.

- Glass transition temperature: $T_g$ = 133°C.

Synthesis Example 2: Preparation of poly[4-(1-ethoxyethoxy)styrene/4-(1-ethoxyethoxy)vinylcyclohexane/4-hydroxystyrene/4-vinylcyclohexanol] having a protecting-group content of 20% and a hydroxyl-group content of 80%.

7.7 g of ethyl vinyl ether area slowly added dropwise to 10°C to a solution of 20.0 g of partially hydrogenated poly-4-hydroxystryene (Maruka Lyncur® PHM-C), a catalytic amount of toluene-4-sulfonic acid and a few drops of pyridine in 120 ml of 1,4-dioxane. The reaction mixture is stirred at room temperature for 3 hours, and the catalyst acid is then removed. The polymer is then precipitated by introducing the resultant reaction solution into an isopropanol/water mixture. The polymer is filtered off, washed with an isopropanol/water mixture and subsequently dried to constant weight under reduced pressure. 17.0 g of a colorless powder are obtained which has the following properties:

- TGA (10°C/min): Δ = 10.9% by weight (in the region below 295°C): → Q = 0.20. This corresponds to a polymer having a protecting-group content of 20% and a hydroxyl-group content of 80%.
- $T_g$ = 126°C.

Synthesis Example 3: Preparation of poly[4-(1-ethoxyethoxy)styrene/4-(1-ethoxyethoxy)vinylcyclohexane/4-hydroxystyrene/4-vinylcyclohexanol] having a protecting-group content of 27% and a hydroxyl-group content of 73%.

8.6 g of ethyl vinyl ether are slowly added dropwise at 10°C to a solution of 20.0 g of partially hydrogenated poly-4-hydroxystyrene (Maruka Lyncur® PHM-C), a catalytic amount of toluene-4-sulfonic acid and a few drops of pyridine in 120 ml of 1,4-dioxane. The reaction mixture is stirred at room temperature for 3 hours, and the catalyst acid is then removed. The polymer is then precipitated by introducing the resultant reaction solution into an isopropanol/water mixture. The polymer is filtered off, washed with an isopropanol/water mixture and subsequently dried to constant weight under reduced pressure. 19.5 g of a colorless powder are obtained which has the following properties:

- TGA (10°C/min): Δ = 13.9% by weight (in the region below 310°C): → Q = 0.27. This corresponds to a polymer having a protecting-group content of 27% and a hydroxyl-group content of 73%.
- $T_g$ = 117°C.

Synthesis Example 4: Preparation of a dissolution inhibitor 17.6 g of 1,3,3,5-tetrakis(p-hydroxyphenyl)pentane,

24.6 g of t-butyl bromoacetate and 21 g of potassium carbonate are dissolved in 250 ml of N,N-dimethylacetamide, and the mixture is stirred at 120°C for 7 hours. The reaction mixture is subsequently introduced into 11 of 1N acetic acid and extracted with 500 ml of ethyl acetate. The solution is filtered through silica gel, and the solvent is removed in vacuo. The white solid (melting point 36-42°C) obtained in this way contains 10-20% of free phenolic groups according to $^1$H-NMR and HPLC.

Use Example 1:

71.8 parts by weight of the polymer from Synthesis Example 2, 25.0 parts by weight of the monomeric inhibitor from Synthesis Example 4, 3.0 parts by weight of phenyl cumyl disulfone and 0.2 part by weight of 4,4'-diaminodiphenyl ether are dissolved in 1-methoxy-2-propyl acetate (photoresist solution 1, solids content 22%).

(a) Measurement of the inhibition (layer removal from unexposed areas); Photoresist solution 1 is filtered through a Teflon membrane filter having a pore diameter of 0.2 μm and spin-coated onto a silicon wafer in such a way that, after predrying for 60 seconds at 120°C on a hotplate, a resist film having a thickness of 0.81 μm is obtained. The wafer coated in this way is immersion-developed in the aqueous 0.262 N tetramethylammonium hydroxide solution that is usual in the process, washed with demineralized water and dried in a stream of nitrogen. Interferrometric measurement shows no measurable reduction in layer thickness.

(b) Solubility contrast

After filtration, photoresist solution 1 is spin-coated onto a silicon wafer in such a way that, after predrying for 60 seconds at 120°C on a hotplate, a resist film having a thickness of 0.815 μm is obtained. The exposure (structuring) is carried out using a 5:1 projection exposure unit (Canon FPA 4500, NA 0,37,248 nm KrF-excimer laser radiation) in 1 mJ/cm$^2$ steps. The wafer is then heated at 120°C for 60 seconds on the hotplate and subsequently developed for 60 seconds in commercially available 0.262 N tetramethylammonium hydroxide solution. The layer thickness remaining after development is measured interferrometrically as a function of exposure dose, and the solubility contrast y is determined in the usual way (R. Dammel: "Diazonaphthoquinone-based Resists", Tutorial Texts in Optical Eng., TT 11, D.C. O'Shea (Ed.), SPIE Opt. Eng. Press, Washington 1993, 10). y = 5.67

While the invention has been described above with reference to specific embodiments thereof, it is apparent that many changes, modifications, and variations can be made without departing from the inventive concept disclosed herein. Accordingly, it is intended to embrace all such changes, mopdifications, and variations that fall within the spirit and broad scope of the appended claims.

## Claims

1. A radiation-sensitive composition comprising, based on the total amount of components A, B and C,

(A) 60-97.9% by weight of at least one polymer having a mean molecular weight $M_w$ (weight average) of from 4000 to 1,000,000 (measured by gel permeation chromatography) and comprising structural repeating units of the formulae I-IV

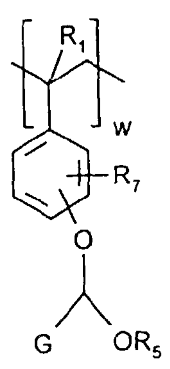

(I),

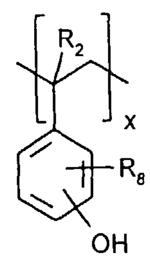

(II),

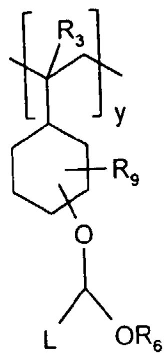

(III),

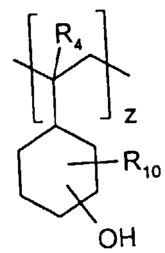

(IV),

in which, $R_1$, $R_2$, $R_3$ and $R_4$, independently of one another, are hydrogen, methyl or halogen, $R_5$ and $R_6$, independently of one another, are $C_1$-$C_6$alkyl or unsubstituted or mono- or poly-$C_1$-$C_4$alkyl-substituted cycloalkyl, $R_7$, $R_8$, $R_9$ and $R_{10}$, independently of one another, are hydrogen, $C_1$-$C_6$alkyl, $C_1$-$C_6$alkoxy or halogen, G is a methyl group, or G and $R_5$, together with the O and C atoms bonded to these radicals, form a five- to eight-membered ring, L is a methyl group, or L and $R_6$, together with the O and C atoms bonded to these radicals, form a five- to eight-membered ring, w, x, y and z are numbers which are equal to or greater than one, with the proviso that $0.05 < Q < 0.40$, where the quotient $Q = (w + y)/(w + x + y + z)$, obtainable from the total number of structural units containing protecting groups divided by the total number of all structural units present,

(B) 2-39.9% by weight of a dissolution inhibitor comprising one or more compounds having a molecular weight of up to 3000 containing at least one acid-labile C-O-C or C-O-Si bond, and

(C) 0.1-20% by weight of a substance which forms an acid on exposure to actinic radiation.

2. A composition according to claim 1, wherein component A is a polymer comprising structural repeating units of the formulae V-VIII

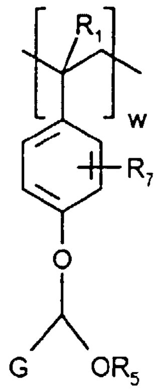

(V),

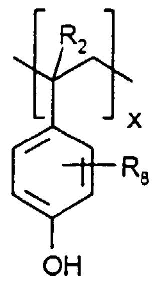

(VI),

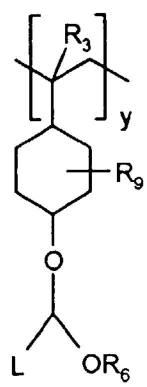

(VII),

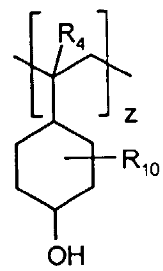

(VIII),

in which $R_1$ to $R_{10}$, G, L, w, x, y and z are as defined in claim 1.

3. A composition according to claim 1, wherein component A is a polymer comprising structural repeating units of the formulae I-IV in which $R_1$ to $R_4$ and $R_7$ to $R_{10}$ are hydrogen.

4. A composition according to claim 1, wherein component A is a polymer comprising structural repeating units of the formulae I-IV in which $R_5$ and $R_6$, independently of one another, are methyl, ethyl, n-propyl, isopropyl, n-butyl, isobutyl, or tert-butyl, or together with G or L and the adjacent O and C atoms, form a tetrahydrofuran or tetrahydropyran ring.

5. A composition according to claim 1, wherein component A is a polymer comprising structural repeating units of the formulae I-IV in which $0.10 \leq Q \leq 0.35$, where the quotient $Q = (w + y)/(w + x + y + z)$, obtainable from the total number of structural units containing protecting groups divided by the total number of all structural units present.

6. A composition according to claim 1, wherein component A is a polymer comprising, based on the total number of all structural units, 1-40% of structural units of the formulae III and IV and 60-99% of structural units of the formulae I and II.

7. A composition according to claim 1, wherein component B is a compound of the formula IXa or IXb

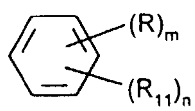

(IXa),

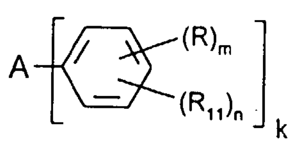

(IXb),

in which A is a k-valent organic radical, k is an integer from 2 to 6, R is an acid-labile group, $R_{11}$ is $C_1$-$C_6$alkyl, $C_1$-$C_6$alkoxy, hydroxyl or halogen, m is an integer from 1 to 5, and n is an integer from 0 to 4, where $n + m \leq 5$.

8. A composition according to claim 7, wherein component B is a compound of the formula IXa or IXb in which R is tetrahydropyranyloxy, tetrahydrofuranyloxy, $-OC(CH_3)R_{12}-OR_{13}$, $-OCR_{14}R_{15}R_{16}$, $-OSi(R_{15})_3$, $-OCR_{17}R_{18}-Ar$, $-OCH_2-CR_{14}=CR_{15}R_{16}$, $-O(CR_{12}R_{14})_p-COOX$ or $-(CR_{12}R_{14})_p-COOX$, where $R_{12}$ is hydrogen, $C_1$-$C_6$alkyl or phenyl, $R_{13}$ is $C_1$-$C_6$alkyl or phenyl, $R_{14}$ is hydrogen or $C_1$-$C_6$alkyl, $R_{15}$ and $R_{16}$ are $C_1$-$C_6$alkyl, $R_{17}$ and $R_{18}$, independently of one another, are hydrogen or $C_1$-$C_6$alkyl, Ar is a $C_5$-$C_{20}$aryl group, and X is tetrahydropyranyl, tetrahydrofuranyl, $-C(CH_3)R_{12}-OR_{13}$, $-CR_{14}R_{15}R_{16}$, $-Si(R_{15})_3$, $-CR_{17}R_{18}-Ar$ or $-CH_2-CR_{14}=CR_{15}R_{16}$ and p is a number from 1 to 4.

**9.** A composition according to claim 7, wherein component B is a compound of the formula X

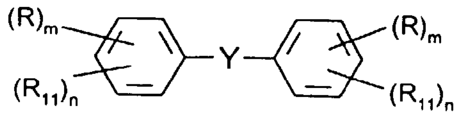

(X),

in which R, $R_{11}$, m and n are as defined in claim 7, and Y is -CO-, -COO-, -SO-, $-SO_2-$ or $-CR_{17}R_{18}-$, in which $R_{17}$ and $R_{18}$, independently of one another, are hydrogen or $C_1$-$C_6$alkyl.

**10.** A composition according to claim 7, wherein component B is a compound of the formula XI, XII, XIII, XIV, XV or XVI

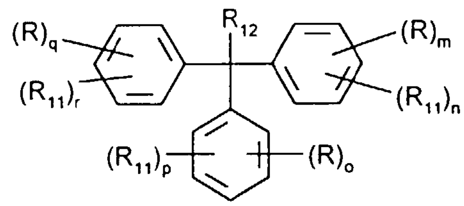

(XI),

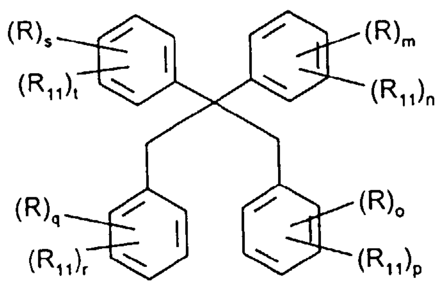

(XII),

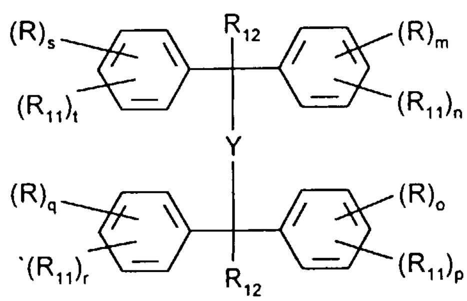

(XIII),

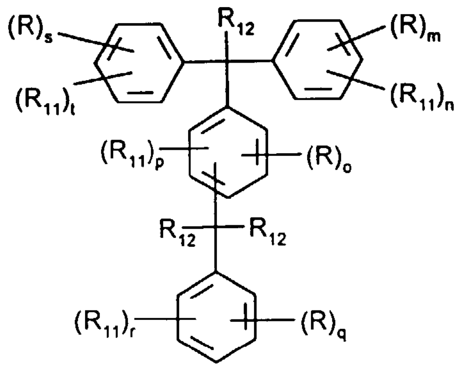

(XIV),

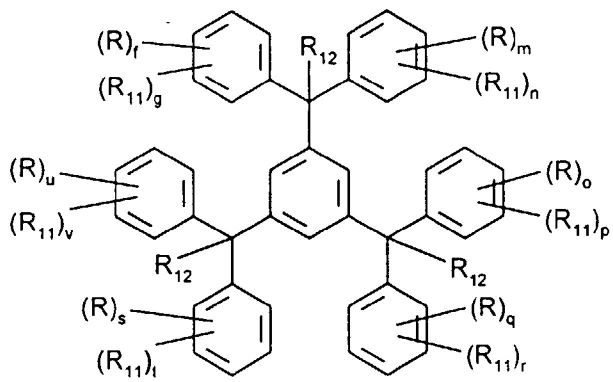

(XV),

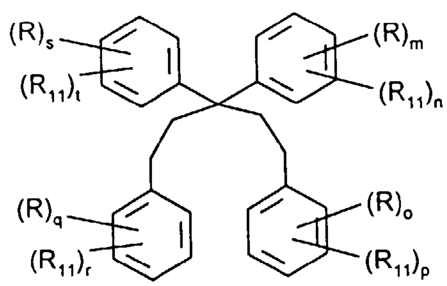

(XVI),

in which R and $R_{11}$ are as defined in claim 7, $R_{12}$ is hydrogen, $C_1$-$C_6$alkyl or phenyl, Y is -CO-, -COO-, -SO-, $-SO_2-$ or $-CR_{17}R_{18}-$, in which $R_{17}$ and $R_{18}$, independently of one another, are hydrogen or $C_1$-$C_6$alkyl, m, o, q, s, u and f are integers from 1 to 5, and n, p, r, t, v and g are integers from 0 to 5, where $n + m \leq 5$, $o + p \leq 5$, $q + r \leq 5$, $s + t \leq 5$, $u + v \leq 5$ and $f + g \leq 5$.

**11.** A composition according to claim 1, wherein component B is a compound whose molecular weight is at most 2000.

**12.** A composition according to claim 1, wherein component C is a disulfone compound.

**13.** A composition according to claim 1, wherein, in addition to components A, B and C, an organic solvent is additionally present as component D.

**14.** A composition according to claim 1, wherein, in addition to components A, B, C and D, an aliphatic or aromatic amine is additionally present as component E.

**15.** A composition according to claim 1, comprising, based on the total amount of components A, B and C, 60-94.9% of component A, 5-30% by weight of component B and 0.1-10% by weight of component C.

**16.** A process for the production of positive images by

(I.) coating of a substrate with a radiation-sensitive composition according to claim 1,
(II.) exposure of the coated substrate to actinic radiation in a predetermined pattern, and
(III.) development of the exposed substrate using a developer for positive-working resists.

**17.** The use of a radiation-sensitive composition according to claim 1 as a positive resist for the production of printing plates, printed circuits or integrated circuits.

**18.** A printing plate, printed circuit or integrated circuit produced using a radiation-sensitive composition according to claim 1.

European Patent Office

# EUROPEAN SEARCH REPORT

Application Number
EP 96 30 1729

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| Y | EP-A-0 628 876 (INTERNATIONAL BUSINESS MACHINES CORPORATION) 14 December 1994<br>* page 8; example 4 *<br>* page 11; example 15 * | 1-18 | G03F7/004 |
| Y,D | DE-A-44 10 441 (FUJI PHOTO FILM CO., LTD.) 29 September 1994<br>* page 15 - page 19 *<br>* page 38 * | 1-18 | |
| | | | TECHNICAL FIELDS SEARCHED (Int.Cl.6) |
| | | | G03F |

The present search report has been drawn up for all claims

| Place of search | Date of completion of the search | Examiner |
|---|---|---|
| THE HAGUE | 10 July 1996 | J.-M. DUPART |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)